# EUROPEAN PATENT SPECIFICATION

(11) **EP 3 664 106 B1**
(45) Date of publication and mention of the grant of the patent: **04.12.2024**
(21) Application number: 18841895.8
(22) Date of filing: 02.08.2018
(51) Int. Cl.: H01F 1/36, H01F 1/37, H05K 9/00

(54) **POWDER COMPRISING COMPOSITE PARTICLES, RESIN COMPOSITION AND MOULDED BODY**
PULVER UMFASSEND KOMPOSITTEILCHEN, HARZZUSAMMENSETZUNG UND FORMKÖRPER
POUDRE COMPRENANT DES PARTICULES COMPOSITES, COMPOSITION DE RÉSINE ET CORPS MOULÉ

(30) Priority: 03.08.2017 JP 2017150792
(43) Date of publication of application: 10.06.2020
(73) Proprietor: Powdertech Co., Ltd., Kashiwa-shi, Chiba 277-8557 (JP)
(72) Inventor: AGA, Koji, Kashiwa-shi, Chiba 277-8557 (JP)
(74) Representative: Vossius & Partner Patentanwälte Rechtsanwälte mbB
(86) International application number: PCT/JP2018/029138
(87) International publication number: WO 2019/027023

(56) References cited:
- EP-A1- 3 196 168
- WO-A1-2012/118061
- WO-A1-2016/043051
- JP-A- 2006 286 729
- JP-A- H03 263 801
- JP-A- H07 183 110
- JP-A- S60 254 514
- KR-A- 20070 097 626
- US-B1- 6 379 589

## Description

### Technical Field

The present invention relates to a powder comprising composite particles, a resin composition, and a molded article.

### Background Art

With miniaturization and weight reduction of an electronic device (e.g., smartphones, etc.) in recent years, electronic components (including a module, board or the like) mounted on the electronic device are also miniaturized and mounted at a high density inside a housing of the electronic device, and are often operated at a high frequency.

Due to such a high-density mounting inside the housing, the distance among the electronic components is short, which makes them more susceptible to electromagnetic noise generated from electronic circuits, and it tends to be a structure in which heat generated from the electronic components is difficult to escape. Therefore, an electronic component that can operate at a higher temperature and a material that can prevent electromagnetic noise are required. In addition, electrification has also progressed in electric vehicles, hybrid vehicles, and the like, and a noise-suppressing material around components that operate at a high temperature for a long time has been required.

It has been known that silver powder is used as an electromagnetic wave-shielding material (see, e.g., Patent Literature 1).

However, in the case where the silver powder is used, there is a problem that an electromagnetic wave-shielding property cannot be sufficiently obtained.

Patent literature 2 discloses a three-layered shielding particle, comprising: a core comprising a ferromagnetic particle; a metal layer coated over said core; and a conductive polymer coated over said metal layer. In certain embodiments, the ferromagnetic particle is a manganese zinc ferrite and the metal layer comprises nickel.

Patent literature 3 refers to Mn-Mg ferrite particles having an average particle size of 1 to 2000 nm and having a spherical shape. The ferrite particles can contain 13 to 25 % by weight of Mn, 1 to 3.5 % by weight of Mg, 43 to 57 % by weight of Fe and 0 to 1.5 % by weight of Sr. The ferrite particles can be surface-treated with an Al compound and / or a coupling agent.

### Citation List

### Patent Literature

Patent Literature 1: JP-A-2016-076444
Patent Literature 2: US 6 379 589 B1
Patent Literature 3: EP 3 196 168 A1

### Summary of Invention

### Technical Problem

An object of the present invention is to provide a composite particle and powder excellent in an electromagnetic wave-shielding property, to provide a molded article excellent in an electromagnetic wave-shielding property, and further to provide a resin composition that can be preferably used for production of the molded article.

### Solution to Problem

The object is achieved by the present invention as defined in the independent claims 1, 6 and 7. Optional features are presented in the dependent claims.

### Advantageous Effects of Invention

According to the present invention, it is possible to provide a composite particle and powder excellent in an electromagnetic wave-shielding property, to provide a molded article excellent in an electromagnetic wave-shielding property, and further to provide a resin composition that can be preferably used for production of the molded article.

### Brief Description of Drawings

[FIG. 1] It is a view showing a cross-sectional SEM image of a composite particle according to Example 1.
[FIG. 2] It is a view showing a cross-sectional SEM image of a composite particle according to Example 2.
[FIG. 3] It is a view showing a cross-sectional SEM image of a composite particle according to Example 3.
[FIG. 4] It is a graph showing measurement results of magnetic permeability in Examples 1 to 3 and Comparative Example 1.

### Description of Embodiments

Hereinafter, preferred embodiments of the present invention will be described in detail.

### (Composite Particle and Powder)

First, a composite particle and powder according to the present invention will be described.

The composite particle according to the present invention contains a base particle formed of a ferrite and a coating layer formed of a material containing at least one selected from the group consisting of Au, Ag, Pt, Ni, and Pd.

The powder according to the present invention contains a plurality of the composite particles according to the present invention.

Accordingly, it is possible to provide a composite particle and powder excellent in an electromagnetic wave-shielding property. Such an excellent effect is obtained by providing a base particle having an excellent electromagnetic wave-absorbing property and a coating layer having an excellent electromagnetic wave reflectivity, which can act synergistically.

Furthermore, it is possible to attain weight reduction by providing the base particle formed of a ferrite, as compared with the case of using a particle formed of only a metal material as described above. Accordingly, the present invention can be preferably applied to, for example, a mobile terminal such as a mobile phone, a smartphone, or a tablet terminal.

In addition, it is possible to reduce the amount of noble metal used, and to attain cost reduction as a whole.

In addition, the composite particle and the powder can be adjusted to have a color tone other than black. More specifically, the color tone of the composite particle or the powder can be adjusted to be golden by providing a coating layer formed of a material containing Au. Furthermore, the color tone of the composite particle or the powder can be preferably adjusted to be color tones from a white color to a silver color by providing a coating layer formed of a material containing at least one selected from the group consisting of Ag, Pt, Ni, and Pd. Accordingly, for example, not only the color tone of the molded article containing the composite particle and the powder can be preferably adjusted to be color tones from a white color to a silver color, but also the molded article can be adjusted to have a desired color tone by making the molded article contain a colorant (including providing a printing layer).

In addition, it is possible to attain excellent conductivity of the composite particle, the powder, and the molded article containing them. In particular, in the case where an external magnetic field is applied under controlled to orient the particles along a magnetic field line when being mixed with a resin and molded, a conductive path (route) can be selectively formed in a specific direction, so as to impart anisotropy to resistance of a resin molded article.

In addition, for example, in a molded article produced by using the powder according to the present invention, particles (composite particles) can be preferably bonded to each other under relatively mild conditions. Accordingly, both the electromagnetic wave-shielding property and mechanical strength of the molded article can be attained at a higher level.

In addition, the frequency characteristic of the magnetic permeability of the composite particles can be controlled by controlling the thickness of the coating layer formed of a material containing highly conductive noble metal.

In contrast, in the particle not having such the constitution as described above, the excellent effects as described above cannot be obtained.

For example, in a particle (simple ferrite particles) not having the such coating layer as described above, an effect of reflection of electromagnetic waves as described above cannot be sufficiently obtained, and the sufficiently excellent electromagnetic wave-shielding property as a whole cannot be attained. In addition, in the case where a molded article is produced as a sintered body by using a composition containing the powder, it is usually necessary to reach a temperature higher than the Curie temperature of ferrite in order to sufficiently improve the bonding strength of particles. Thus, in a finally obtained molded article, it is difficult to exhibit sufficient characteristics. In the case where sintering treatment is performed at a temperature lower than the Curie temperature, the strength of the molded article is insufficient. In addition, since the color tone of the particle is a black color with low brightness, it is difficult to adjust the color tone of the molded article containing the powder. In addition, the sufficiently excellent conductivity of the particle, the powder, and the molded article containing them cannot be attained.

Even in the case where the coating layer is provided on a surface of the ferrite particle, the effect of reflection of electromagnetic waves as described above cannot be sufficiently obtained and the sufficiently excellent electromagnetic wave-shielding property as a whole cannot be attained in the case where a constituent material of the coating layer are not that as described above.

In addition, in the case where a simple metal particle (a particle not having a base particle formed of ferrite) is used, the effect of absorbing electromagnetic waves as described above cannot be sufficiently obtained and the sufficiently excellent electromagnetic wave-shielding property as a whole cannot be attained. In addition, specific gravity of the entire particles is increased, and it is difficult to attain weight reduction of the powder or the molded article. In addition, in general, production cost of the powder or the molded article increases.

### (Base Particle)

The base particle is formed of a ferrite.

The base particle may be formed of a ferrite, and may contain, for example, a hard ferrite, and is preferably formed of a soft ferrite.

Accordingly, the magnetic permeability can be easily controlled in a wide frequency range (e.g., 1 MHz to 1 GHz) by adjusting the composition of the base particle and the thickness of a surface coating layer.

In the present invention, the ferrite constituting the base particle has a composition containing Fe in an amount of 48 mass% or more and 65 mass% or less, Mn in an amount of 10 mass% or more and 25 mass% or less, Mg in an amount of 0.1 mass% or more and 6 mass% or less, and Sr in an amount of 1 mass% or less.

The case where the content of Fe is 48 mass% or more is preferable because magnetization is difficult to decrease and the magnetic permeability is difficult to be reduced.

The case where the content of Fe is 65 mass% or less is preferable because the composition is difficult to be close to magnetite, oxidization is difficult to occur and the magnetization is difficult to decrease although depending on production conditions, and the magnetic permeability is difficult to decrease.

The case where the content of Mn is 10 mass% or more is preferable because the composition is difficult to be close to magnetite, oxidization is difficult to occur and the magnetization is difficult to decrease although depending on production conditions, and the magnetic permeability is difficult to decrease.

The case where the content of Mn is 25 mass% or less is preferable because the content of Fe is relatively difficult to decrease, the magnetization is difficult to decrease, and the magnetic permeability is difficult to decrease.

The case where the content of Mg is 0.1 mass% or more is preferable because the effect of adding Mg is obtained, and the magnetization is easy to control.

The case where the content of Mg is 6 mass% or less is preferable because Mg is difficult to be precipitated in the form of MgO on the surface of the particles when a raw material is sprayed during formation of the base particles, it is difficult to adsorb moisture in the air over time, MgO is less likely to change to Mg(OH)₂ or MgCO₃, and it is less likely to lead to long-term fluctuations in electrical resistance when used after being mixed with resin after surface coating of the base particles.

The case where the content of Sr is 1 mass% or less is preferable because Sr is less likely to be precipitated in the form of SrO on the surface of the particles when a raw material is sprayed during formation of the base particles, it is difficult to adsorb moisture in the air over time, SrO is less likely to change to Sr(OH)₂ or SrCO₃, and it is less likely to lead to long-term fluctuations in electrical resistance when used after being mixed with resin after surface coating of the base particles.

The content of Sr is preferably more than 0 mass%, and more preferably 0.1 mass% or more.

In the ferrite, the content of Fe is 48 mass% or more and 65 mass% or less, and preferably 49 mass% or more and 63 mass% or less.

In the ferrite, the content of Mn is 10 mass% or more and 25 mass% or less, and preferably 10 mass% or more and 20 mass% or less.

In the ferrite, the content of Mg is 0.1 mass% or more and 6 mass% or less, and preferably 0.2 mass% or more and 2.5 mass% or less.

In the ferrite, the content of Sr is 1 mass% or less, and preferably 0.1 mass% or more and 0.75 mass% or less.

In the ferrite, a component other than Fe, Mn, Mg, and Sr may be contained as a metal component, and it is preferable to contain only Fe, Mn, Mg, and Sr as the metal component.

The Curie point (also referred to as the Curie temperature) of the ferrite constituting the base particle is preferably 200°C or higher and 500°C or lower, and more preferably 200°C or higher and 450°C or lower.

The Curie point can be calculated from, for example, a temperature dependence curve (temperature change) of magnetization obtained by measuring a change of magnetization with temperature by a vibration sample magnetometer (VSM).

In the sample measurement, a sample, which was placed in a copper sample cell, was set in a sample cell, and the magnetization was measured while increasing the temperature from room temperature to 500°C at a rate of 2°C/min. A point at which the magnetization becomes 0 in the obtained change of the magnetization with temperature was defined as the Curie point.

Accordingly, it is possible to attain excellent heat resistance of the composite particle and the molded article or the like produced by using the composite particles, and for example, it can be preferably applied to a molded article used in a high-temperature environment.

In contrast, in the case where the Curie temperature is too low, the heat resistance of the composite particle and the molded article or the like produced by using the composite particles may decrease, and there is a possibility that applicable component, member, place, and the like are limited.

In addition, there is no problem in the fact that the Curie temperature is too high, but the Curie point of the ferrite depends on the composition and generally does not exceed 500°C in the above ferrite composition.

A shape of the base particle is not particularly limited, and is preferably a spherical shape.

Accordingly, in the molded article produced by using the powder according to the present invention, the filling rate of the powder can be further increased, and the shielding property (absorbing property and reflectivity) of the electromagnetic wave can be further improved.

In the present specification, the term "spherical shape" refers to a shape of sphere or that close enough to sphere, and more specifically, means to have a shape factor SF-1 of 100 or more and 120 or less.

The shape factor SF-1 of the base particles is preferably 100 or more and 120 or less, and more preferably 100 or more and 115 or less.

The shape factor SF-1 of the particles can be determined as follows.

First, 1,000 or more particles are automatically measured in terms of equivalent circle diameter, outer circumference, length, width, and area, automatically by using a scanning electron microscope (e.g., FE-SEM (SU-8020, manufactured by Hitachi High-Technologies Corporation), etc.) and energy dispersive X-ray analysis (EDX) (e.g., E-MAX manufactured by Horiba, ltd.), setting the magnification such that the particles fall within a range of about 3 to 50 in one field of view (e.g., set to be 1,000 to 2,000 times in Examples 1-3 and Comparative Example 1 to be described below), and by using a particle analysis function that is an accompanying function of EDX.

Data of those in which particles apparently overlap each other (peripheral length of which is 1.8 times or more of the peripheral length calculated from the circle equivalent diameter) and the fine powder (equivalent circle diameter of which is smaller than 1 µm) are excluded from the obtained data, the length is defined as the maximum ferret diameter R, and the area is defined as a projected area S, so that the values of SF-1 are calculated by the following formula. The closer the particle shape is to a spherical shape, the closer the value to 100.

SF-1 = (R²/S) × (π/4) × 100 (in the formula, R represents the circle equivalent diameter (µm) and S represents Area (projection area, unit µm²).

SF-1 is calculated for each particle, and an average value of 200 or more particles can be adopted as SF-1 of the ferrite powder.

The base particles constituting a single composite particle may be formed of, for example, a single particle, or may be a bonded body (including an aggregate) of a plurality of fine particles.

The base particles are formed of a material containing a ferrite and may contain a component other than the ferrite

The content of the component other than the ferrite in the base particles is preferably 1.0 mass% or less, more preferably 0.7 mass% or less, and still more preferably 0.5 mass% or less.

Accordingly, the effects of the present invention as described above are more reliably exhibited.

### (Coating Layer)

The coating layer covers at least a part of the base particle. In the present invention , the coating layer is formed of a material containing at least one selected from the group consisting of Au, Ag, Pt, Ni, and Pd.

The above metal elements (Au, Ag, Pt, Ni, and Pd) may be contained as a single metal in the coating layer, or may be contained as a constituent component of an alloy.

The coating layer may be formed of a material containing at least one selected from the group consisting of Au, Ag, Pt, Ni, and Pd, and among them, at least one of Au and Ag is preferred, and Ag is more preferred as a constituent material of the coating layer.

Even among metals constituting the above group, Au and Ag have a relatively low melting point, and thus in the case of producing a molded article as a sintered body, the composite particles can be preferably bonded with each other even in the case of sintering at a relatively low temperature. In addition, the frequency characteristics of the magnetic permeability of the composite particles can be more preferably controlled by controlling the thickness of the coating layer.

The content (total amount in the case of containing a plurality of elements) of at least one selected from the group consisting of Au, Ag, Pt, Ni, and Pd in the coating layer is preferably 80 mass% or more, and more preferably 90 mass% or more.

The sum of the contents of Au and Ag in the coating layer is preferably 80 mass% or more, and more preferably 90 mass% or more.

Accordingly, the effects described above are more reliably exhibited.

The thickness of the coating layer is not particularly limited, and is preferably 10 nm or more and 500 nm or less, more preferably 20 nm or more and 400 nm or less, and still more preferably 30 nm or more and 300 nm or less.

The thickness of the coating layer can be determined by the following method.

That is, the particles were embedded in a resin, and then the particles were subjected to cross section treatment using an ion milling device to prepare a sample for imaging.

The obtained sample for imaging is imaged by FE-SEM, and the thickness of the sample can be calculated by using length of a scale (described value) in an image analysis software or in the image, an actual measurement value of the scale in the SEM image measured by a ruler, and an actual measurement value of the thickness of the coating layer measured by a ruler.

As Fe-SEM, SU-8020 manufactured by Hitachi High-Technologies Corporation was used.

As an ion milling device, IM-4000 manufactured by Hitachi High-Technologies Corporation was used.

As the resin for embedding, an epoxy resin was used.

Accordingly, electromagnetic waves can be reflected more effectively while the amount of metal used is reduced.

When a particle diameter of the composite particle is defined as D [µm] and the thickness of the coating layer is defined as T [µm], a relationship of 0.0010 ≤ T/D ≤ 0.10 is preferably satisfied, a relationship of 0.0030 ≤ T/D ≤ 0.080 is more preferably satisfied, and a relationship of 0.0050 ≤ T/D ≤ 0.050 is still more preferably satisfied.

The particle diameter of the above composite particle is a volume average particle diameter. The volume average particle diameter can be measured by a method described below.

Accordingly, it is possible to attain more preferred balance between absorption of the electromagnetic wave and reflection of the electromagnetic wave, and to attain particularly excellent electromagnetic wave-shielding effect as a whole.

The composite particle of the present invention may contain other configurations as long as it contains the base particle and the coating layer as described above.

For example, the composite particle may contain at least one intermediate layer between the base particle and the coating layer.

In addition, a coat layer, which is formed of a material other than Au, Ag, Pt, Ni, and Pd, may be provided on a surface of the coating layer described above. Examples of such a coat layer include a surface treatment layer with various coupling agents such as silane coupling agents and the like.

In addition to the coating layer (first coating layer) formed of the material containing at least one selected from the group consisting of Au, Ag, Pt, Ni, and Pd, another coating layer (second coating layer) formed of a material other than Au, Ag, Pt, Ni, and Pd may be provided on the surface of the base particle.

The volume average particle diameter of the composite particles is 2.0 µm or more and 15 µm or less.

Accordingly, when the composite particles are mixed with a resin and formed into a molded article, it is easy to create a state in which the gaps among particles are reduced and the magnetic material (base particles) are densely packed.

The volume average particle diameter can be determined, for example, by the following measurement. That is, first, in a 100ml-beaker were placed 10 g of powder serving as a sample and 80 ml of water, and thereto were further added 2 to 3 drops of dispersants (sodium hexametaphosphate). Next, the obtained solution was dispersed by using an ultrasonic homogenizer (e.g., UH-150, manufactured by SMT Co. LTD.). In the case where UH-150 manufactured by SMT Co. LTD. is used as the ultrasonic homogenizer, for example, the output level may be set to 4, and the dispersion may be performed for 20 seconds. Thereafter, bubbles generated on the surface of the beaker were removed, and the dispersed solution was introduced into a micro track particle diameter analyzer (e.g., Model 9320-X100 or the like, manufactured by Nikkiso Co., Ltd.) and was measured.

Composite particles in which a coating layer is formed on base particles formed of ferrite tend to agglomerate in water and may not be measured with high accuracy in some cases. In this case, the volume average particle diameter can be calculated by using image analysis data of the particles described above.

That is, when the circle-equivalent diameter of the i-th particle is defined as dᵢ and the volume of the particle is defined as Vᵢ, Vᵢ can be calculated as Vᵢ = 4/3 × π × (dᵢ/2)³, and the volume average diameter D₅₀ can be calculated as D₅₀ = Σ (Vᵢ·dᵢ)/Σ (Vᵢ) by using the data of the particles used when SF-1 is calculated by particle analysis results.

Electric resistivity (volume resistivity) of the powder according to the present invention at 25°C is preferably 10 Q cm or lower, more preferably 1.0 × 10⁻¹ Ω·cm or lower, and still more preferably 1.0 × 10⁻² Ω·cm or lower.

As a result, when the composite particles are mixed with a resin and formed into a molded article (although depending on a mixing ratio with the resin), a conductive path can be easily formed, and the resistance of the resin molded article can be reduced more effectively.

The powder according to the present invention may contain a plurality of the composite particles according to the present invention, and may further contain particles other than the composite particles according to the present invention.

In such a case, the content of the particles other than the composite particles according to the present invention in the powder according to the present invention is preferably 10 mass% or less, more preferably 5.0 mass% or less, and still more preferably 1.0 mass% or less.

Accordingly, the effects of the present invention as described above are more reliably exhibited.

### (Method of Producing Composite Particle)

Next, a method of producing the composite particle according to the present invention will be described.

The composite particle according to the present invention can be produced, for example, by forming a coating layer by various plating methods on a surface of a ferrite particle produced by a predetermined method.

Examples of the plating method for forming the coating layer include wet plating methods such as electrolytic plating and electroless plating, dry plating methods such as vacuum deposition, sputtering, and ion plating, and the like, and the wet plating methods are preferred and the electroless plating is more preferred.

The ferrite particles to be the base particles may be produced by any method, and can be preferably produced, for example, by a method described below.

For example, the ferrite particles to be the base particles can be preferably produced by spraying a ferrite raw material prepared at a predetermined composition in the atmosphere, followed by rapid cooling and solidifying.

In this method, a granulated product can be preferably used as the ferrite raw material.

The method for preparing the ferrite raw material is not particularly limited, and for example, a dry method may be used, or a wet method may be used.

An example of the method for preparing a ferrite raw material (granulated product) is as follows.

That is, a plurality of types of raw materials containing metal elements are weighed and mixed so as to correspond to the composition of ferrite particles (base particles) to be produced, and then water is added thereto, followed by pulverizing to prepare slurry. The prepared pulverized slurry is granulated by a spray drier and classified to prepare a granulated product having a predetermined particle diameter.

Another example of the method for preparing a ferrite raw material (granulated product) is as follows.

That is, a plurality of types of raw materials containing metal elements are weighed and mixed so as to correspond to the composition of ferrite particles (base particles) to be produced, then dry grinding is performed such that each of the raw materials is pulverized and dispersed, and the mixture is granulated with a granulator and classified to prepare a granulated product having a predetermined particle diameter.

The granulated product prepared as described above is thermally sprayed to convert into a ferrite in the atmosphere.

A mixed gas containing combustion gas and oxygen gas, serving combustion flame of combustible gas, can be used for the thermal-spraying.

The volume ratio of the combustion gas to the oxygen gas is preferably 1:3.5 or more and 1:6.0 or less.

Accordingly, formation of particles having a relatively small particle diameter can proceed preferably by condensation of the volatilized material. In addition, the shape of the ferrite particle (base particle) to be obtained can be adjusted preferably. In addition, treatment such as classification in a later step can be omitted or simplified, and more excellent productivity of the ferrite particles (base particles) can be attained. In addition, the proportion of particles to be removed by classification in the later step can be further reduced, and more excellent yield of the ferrite particles (base particles) can be attained.

For example, oxygen gas can be used at a ratio of 35 Nm³hr or more and 60 Nm³hr or less per 10 Nm³hr of combustion gas.

Examples of the combustion gas used in the thermal-spraying include propane gas, propylene gas, acetylene gas, and the like. Among them, the propane gas can be used preferably.

In addition, nitrogen gas, oxygen gas, air, or the like can be used as a granulated product-transporting gas to transport the granulated product into combustible gas.

The flow rate of the granulated product to be transported is preferably 20 m/s or higher and 60 m/s or lower.

The thermal-spraying is preferably performed at a temperature of 1,000°C or higher and 3,500°C or lower, and more preferably 2,000°C or higher and 3,500°C or lower.

In the case where the above-mentioned conditions are satisfied, the formation of particles having a relatively small particle diameter can proceed more preferably by condensation of the volatilized material. In addition, the shape of the ferrite particle (base particles) to be obtained can be adjusted more preferably. In addition, treatment such as classification in a later step can be omitted or simplified, and more excellent productivity of the ferrite particles (base particles) can be attained. In addition, the proportion of particles to be removed by classification in the later step can be further reduced, and more excellent yield of the ferrite particles (base particles) can be attained.

The ferrite particles that have been thermally sprayed and ferritized in this manner are rapidly cooled and solidified in water or atmosphere, and are collected by a filter.

Thereafter, the ferrite particles recovered by the filter for collection are classified as necessary. A conventionally known air classification, a mesh filtration method, a sedimentation method, and the like are used as a classification method to adjust the diameter to a desired particle diameter. The ferrite particles can be recovered by separating from particles having a large particle diameter by a cyclone or the like.

In addition, the ferrite particles (base particles) can be preferably produced by the following method (second method).

That is, the ferrite particles (base particles) can be produced, for example, by a method that includes a calcination step of pelletizing a composition containing a ferrite raw material, followed by calcination to obtain a calcined body, and a main-firing step of firing the calcined powder after pulverizing and classifying the calcined body.

As a result, the ferrite particles used in the production of composite particles having the shape and size as described above can be produced more efficiently. In addition, unlike a wet granulation method using acid or alkali, it is possible to effectively prevent impurities or the like derived from acid or alkali from remaining in the ferrite particles (base particles) in the production process, and to attain more excellent durability and reliability of the composite particle, the resin composition produced by using the composite particle, and the molded article.

The production of pellets can be preferably performed by using a pressure-molding machine.

The heating temperature in the calcination step is not particularly limited, and is preferably 600°C or higher and 1,200°C or lower, more preferably 650°C or higher and 1,000°C or lower, and still more preferably 700°C or higher and 900°C or lower.

Accordingly, it is possible to preferably pulverize the calcined body, and to more preferably produce the ferrite particles used in the production of the composite particles having the shape and size as described above.

In the calcination step, heat treatment (firing treatment) including two or more stages may be performed.

In the main-firing step, a calcined body having an irregular shape, which has been subjected to a pulverization treatment, is provided.

The volume average particle diameter of the calcined body provided to the main-firing step is preferably 0.5 µm or more and 30 µm or less, and more preferably 0.5 µm or more and 20 µm or less.

Accordingly, the ferrite particles used in the production of the composite particles having the shape and size as described above can be produced more efficiently. In addition, the treatment such as classification in a later step can be omitted or simplified, and more excellent productivity of the ferrite particles can be attained. In addition, the ratio of the particles to be removed by classification in the later step can be reduced, and more excellent yield of the ferrite particles can be attained.

The main-firing step is preferably performed, for example, on a granulated product obtained by granulating powder (powder obtained with pulverization and classification treatment) of the calcined body.

Accordingly, the ferrite particles used in the production of the composite particles having the shape and size as described above can be produced more efficiently. In addition, the treatment such as classification in a later step can be omitted or simplified, and more excellent productivity of the ferrite particles can be attained. In addition, the proportion of particles to be removed by classification in the later step can be further reduced, and more excellent yield of the ferrite particles can be attained.

The main-firing can be preferably performed by thermally spraying the powder of the calcined body in the atmosphere.

A mixed gas containing combustion gas and oxygen gas, serving combustion flame of combustible gas, can be used for the thermal-spraying.

The volume ratio of the combustion gas to the oxygen gas is preferably 1:3.5 or more and 1:6.0 or less.

Accordingly, formation of ferrite particles having a relatively small particle diameter can proceed preferably by condensation of the volatilized material. In addition, the shape of the ferrite particle to be obtained can be adjusted more preferably. In addition, treatment such as classification in a later step can be omitted or simplified, and more excellent productivity of the ferrite particles can be attained. In addition, the proportion of particles to be removed by classification in the later step can be further reduced, and more excellent yield of the ferrite particles can be attained.

For example, oxygen gas can be used at a ratio of 35 Nm³hr or more and 60 Nm³hr or less per 10 Nm³hr of combustion gas.

Examples of the combustion gas used in the thermal-spraying include propane gas, propylene gas, acetylene gas, and the like. Among them, the propane gas can be used preferably.

In addition, nitrogen gas, oxygen gas, air, or the like can be used as a granulated product-transporting gas to transport the granulated product into combustible gas.

The flow rate of the granulated product to be transported is preferably 20 m/s or higher and 60 m/s or lower.

The thermal-spraying is preferably performed at a temperature of 1,000°C or higher and 3,500°C or lower, and more preferably 2,000°C or higher and 3,500°C or lower.

In the case where the above-mentioned conditions are satisfied, the formation of ferrite particles having a relatively small particle diameter can proceed more preferably by condensation of the volatilized material. In addition, the shape of the ferrite particle to be obtained can be adjusted more preferably. In addition, treatment such as classification in a later step can be omitted or simplified, and more excellent productivity of the ferrite particles can be attained. In addition, the proportion of particles to be removed by classification in the later step can be further reduced, and more excellent yield of the ferrite particles can be attained.

Subsequently, the ferrite particles formed through the main-firing by thermal-spraying are transported in the atmosphere on airflow of supplied air to perform rapid-cooling and solidifying, and then, ferrite particles in a predetermined particle diameter range are collected and recovered.

The collection can be performed by a method in which the rapidly cooled and solidified ferrite particles are transported on the airflow of the supplied air, and by utilizing the fact that particles having a large particle diameter fall in the middle of airflow transportation while the other particles are transported by airflow to an downstream side, ferrite particles in a predetermined particle diameter range is collected by a filter provided on the downstream side of the airflow.

When the flow rate during the airflow transportation is set to 20 m/s or higher and 60 m/s or lower, particles having a large particle diameter can be made to drop with particularly high selectivity, and the ferrite particles in a predetermined particle diameter range can be recovered more efficiently. In the case where the flow rate is too low, even particles with a relatively small particle diameter fall in the middle of the airflow transportation. Accordingly, the average particle diameter of ferrite particles collected at the downstream side of the airflow becomes too small, or the absolute amount of the ferrite particles collected at the downstream side of the airflow is reduced, causing decrease in the productivity. In contrast, in the case where the flow rate is too high, even particles having a relatively large particle diameter are transported to the downstream side. Accordingly, the average particle diameter of the ferrite particles recovered at the downstream side of the airflow is likely to be too large.

Then, the recovered ferrite particles may be classified as necessary.

### (Resin Composition)

Next, the resin composition according to the present invention will be described.

The resin composition according to the present invention contains the powder according to the present invention and a resin material.

Accordingly, it is possible to provide a resin composition that can be preferably used in production of a molded article excellent in the electromagnetic wave-shielding property.

Examples of the resin material constituting the resin composition include epoxy resins, urethane resins, acrylic resins, silicone resins, various modified silicone resins (acrylic-modified, urethane-modified, epoxy-modified, fluorine), polyamide resins, polyimide resins, polyamideimide resins, fluorine, and the like. One kind or two or more kinds in combination selected therefrom can be used.

The resin composition may contain components (other components) other than the powder according to the present invention and the resin material.

Examples of such components include a solvent, a filler (an organic filler, an inorganic filler), a plasticizer, an antioxidant, a dispersant, a colorant such as a pigment, thermally conductive particles (particles having high thermal conductivity), and the like.

The ratio (content) of the powder according to the present invention to the total solid content in the resin composition is preferably 50 mass% or more and 95 mass% or less, and more preferably 80 mass% or more and 95 mass% or less.

Accordingly, it is possible to attain excellent dispersion stability of the powder according to the present invention in the resin composition, excellent storage stability of the resin composition, and excellent moldability of the resin composition, and at the same time, to attain more excellent mechanical strength of the molded article produced by using the resin composition, a more excellent electromagnetic wave-shielding property, and the like.

The ratio (content) of the resin material to the total solid content in the resin composition is preferably 5 mass% or more and 50 mass% or less, and more preferably 5 mass% or more and 20 mass% or less.

Accordingly, it is possible to attain excellent dispersion stability of the powder according to the present invention in the resin composition, excellent storage stability of the resin composition, and excellent moldability of the resin composition, and at the same time, to attain more excellent mechanical strength of the molded article produced by using the resin composition, a more excellent electromagnetic wave-shielding property, and the like.

### (Molded Article)

Next, the molded article according to the present invention will be described.

The molded article according to the present invention is produced by using a material containing the powder according to the present invention and a resin material.

Accordingly, a molded article excellent in the electromagnetic wave-shielding property can be provided.

The molded article according to the present invention may have many applications, and is preferably an electromagnetic wave-shielding material.

Accordingly, the effect of the present invention as described above is more remarkably exhibited.

The molded article according to the present invention can be preferably produced by using the resin composition according to the present invention as described above.

Examples of the molding method of the molded article include compression molding, extrusion molding, injection molding, blow molding, calendar molding, various coating methods, and the like. The molded article may be formed, for example, by applying the resin composition directly onto a member on which a molded article is to be formed, or may be placed on a target member (e.g., printed wiring board, metal foil (e.g., copper foil, etc.), etc.) after being separately produced.

The powder according to the present invention may be used without steps such as mixing or dispersing in a resin or the like and firing, and for example, the powder may be used for the production of the molded article as a sintered body after performing steps such as molding the powder in a desired shape, granulating, and coating, and then firing.

The preferred embodiments of the present invention have been described above, but the present invention is not limited thereto.

For example, the method of producing the composite particle according to the present invention may contain, as necessary, another step (a pretreatment step, an intermediate step, and a post-treatment step) in addition to the steps described above.

The composite particle according to the present invention are not limited to those produced by the method described above, and may be produced by any method.

In the embodiment described above, the case where the composite particle, powder and resin composition according to the present invention are used for production of an electromagnetic wave-shielding material has been representatively described. However, the composite particle, powder and resin composition according to the present invention may be used for productions of those other than the electromagnetic wave-shielding material. For example, the composite particle and powder according to the present invention may be used as a magnetic core material or a filler (in particular, a magnetic filler).

### Examples

Hereinafter, the present invention will be described in detail based on Examples and Comparative Examples, but the present invention is not limited thereto. In the following description, treatments and measurements whose temperature conditions are not specifically shown were performed at room temperature (25°C).

The unit 1 emu/g corresponds to 1 Am²/kg and the unit 1 Oe corresponds to 1000/4π A/m.

### (1) Production of Composite Particle and Powder

Composite particles and powder of Examples and Comparative Examples were produced as follows.

### (Example 1)

First, Fe₂O₃, Mn₃O₄, Mg(OH)₂, and SrCO₃ as raw materials were mixed at a predetermined ratio and mixed with a Henschel mixer for 15 minutes.

The thus-obtained pulverized product was pelletized by using a roller compactor, and then calcined in the atmosphere at 900°C for five hours by using a rotary kiln.

After the calcination, the resultant was ground with a ball mill to obtain a calcined body (calcined powder) in the form of powder having a volume average particle diameter of 1.8 µm.

Next, the obtained calcined body in the form of powder was used and a thermal-spraying was performed in combustion flame of combustible gas of propane : oxygen = 10 Nm³/hr : 35 Nm³/hr under a condition of a flow rate of 40 m/s. At this time, the granulated product was thermally sprayed while continuously flowing, so that the particles after thermal-spraying and rapidly-cooling were independent without being bound to each other. Subsequently, the cooled particles were recovered by a cyclone provided on the downstream side of the airflow. Accordingly, ferrite powder (volume average particle diameter: 27.5 µm) containing a plurality of ferrite particles was obtained. The obtained ferrite powder was classified by air flow to obtain a volume average particle diameter of 7.5 µm.

The volume average particle diameter of the powder was determined by the following measurement. That is, first, in a 100ml-beaker were placed 10 g of powder serving as a sample and 80 ml of water, and thereto were further added 2 drops of dispersants (sodium hexametaphosphate). Next, the obtained solution was dispersed by using an ultrasonic homogenizer (UH-150, manufactured by SMT Co. LTD.). At this time, the output level of the ultrasonic homogenizer was set to 4, and dispersion was performed for 20 seconds. Thereafter, bubbles generated on the surface of the beaker were removed, and the dispersed solution was introduced into a micro track particle diameter analyzer (e.g., Model 9320-X100 or the like, manufactured by Nikkiso Co., Ltd.) and was measured. The following Examples and Comparative Examples were also determined in the same manner.

The average value of SF-1 of the ferrite powder was 110.

The shape factor SF-1 was determined as follows.

First, 1,000 or more particles were automatically measured in terms of equivalent circle diameter, outer circumference, length, width, and area, automatically by using a scanning electron microscope (FE-SEM (SU-8020, manufactured by Hitachi High-Technologies Corporation)) and EDX (E-MAX, manufactured by Horiba, ltd.) and by setting the magnification to 1,000 times and using a particle analysis function that is an accompanying function of EDX.

Data of those in which particles apparently overlap each other (peripheral length of which is 1.8 times or more of the peripheral length calculated from the circle equivalent diameter) and the fine powder (equivalent circle diameter of which is smaller than 1 µm) were excluded from the obtained data, the length was defined as the maximum ferret diameter R, and the area was defined as a projected area S, so that the values of SF-1 were calculated by the above formula.

SF-1 was calculated for each particle, and an average value of 200 or more particles was defined as SF-1 of the ferrite powder. The following Examples and Comparative Examples were also determined in the same manner.

In addition, the BET specific surface area of the obtained ferrite powder was 0.74 m²/g.

The BET specific surface area was determined by a measurement using a specific surface area measurement device (model: Macsorb HM model-1208 (manufactured by Mountech Co. Ltd.)). More specifically, in a standard sample cell dedicated to a specific surface area measurement device were placed about 5 g of measurement sample, the sample (ferrite powder) was accurately weighed by a precision balance and set in a measurement port, and measurement was started. The measurement was performed by a one-point method, and the BET specific surface area was automatically calculated when the weight of the sample was input at the end of the measurement. As a pretreatment before the measurement, about 20 g of measurement samples were divided on a weighing paper, followed by being deaerated by a vacuum dryer to - 0.1 MPa, and were heated for two hours at 200°C after it was confirmed that the degree of vacuum had reached -0.1 MPa or lower. The measurement conditions were at a temperature of 10 to 30°C and a humidity of 20 to 80% in relative humidity, and under a condition at which condensation is not occurred.

When the ferrite powder was measured by using a vibrating sample magnetic measurement device, saturation magnetization was 69.6 emu/g, residual magnetization was 2.724 emu/g, and coercive force of the ferrite powder was 38.23 Oe.

The above magnetic properties were determined as follows. That is, first, ferrite powder to be measured was packed in a cell having an inner diameter of 5 mm and a height of 2 mm, and was set in a vibrating sample magnetic measurement device (VSM-C7-10A, manufactured by Toei Industry Co., Ltd.). Next, an applied magnetic field was applied and swept up to 5 kOe, and then the applied magnetic field was reduced to create a hysteresis curve. Thereafter, the saturation magnetization, residual magnetization and coercive force of the ferrite powder were determined from data of the curve. Those of the powder as aggregate of composite particles described below were also determined in the same manner. In addition, those of the Examples and Comparative Examples described below were also determined in the same manner.

First, 0.2 g of the obtained ferrite powder was weighed, thereto was added a mixture prepared by adding 20 ml of 1N hydrochloric acid and 20 ml of 1N nitric acid to 60 ml of pure water, followed by heating, so as to prepare an aqueous solution in which the ferrite powder was completely dissolved. The contents of Fe, Mn, Mg, and Sr were measured by using an ICP analyzer (ICPS-1000IV, manufactured by Shimadzu Corporation). In addition, those of the Examples and Comparative Examples described below were also determined in the same manner.

Thereafter, the obtained ferrite powder was subjected to an electroless plating to obtain powder containing a plurality of composite particles that have a coating layer formed of Ag, on the surface of the base particles formed of ferrite.

### (Examples 2 and 3)

Powder (aggregate of a plurality of composite particles) was produced in the same manner as in Example 1 except that calcination conditions, thermal-spray treatment conditions, and classification conditions were adjusted so as to give the conditions of the powder (aggregate of a plurality of composite particles) shown in Tables 1 and 2.

### (Comparative Example 1)

Powder was produced in the same manner as in Example 1 except that the formation of the coating layer on the ferrite powder was omitted. That is, in the present Comparative Example, the ferrite powder was used as a target powder directly.

The constitutions of the powders in the above Examples and Comparative Example were summarized in Tables 1 and 2.

The color tone of the powder in each Example was a white color to a silver color, whereas the color tone of the powder in the Comparative Example was a black color.

In each of the Examples, the content of components other than ferrite in the base particle was 0.1 mass% or less.

In each of the Examples, the content of components other than Ag in the coating layer was 0.1 mass% or less. The content of Ag in the coating layer was determined by measurement using fluorescent X-rays. That is, in the Examples, Ag powder in an amount of 0.1 parts by mass, 0.5 parts by mass, and 1 part by mass was respectively mixed with 100 parts by mass of ferrite particles serving as base particles by ball mill (100 rpm) for 30 minutes, and then intensity of Ag was measured by an X-ray fluorescence measurement device (ZSX100s, manufactured by Rigaku Corporation) to create a calibration curve. Then, intensity of Ag was measured for the powder (aggregate of a plurality of composite particles) in each of the above Examples by the X-ray fluorescence measurement device, and the content of Ag was calculated.

In addition, the thickness (T) of the coating layer was measured by the method described above.

In each of the Examples, the content of the component other than the composite particles in the powder was 0.1 mass% or less.

Values of the volume average particle diameter as a whole, magnetic properties, and SF-1 of the powder (aggregate of a plurality of composite particles) in each of the Examples and the Comparative Example were determined in the same manner as the measurement of the ferrite particles described above.

The tap density was measured by using a USP tap density measurement device (manufactured by Hosokawa Micron Corporation) in accordance with JIS R 1628.

The true specific gravity was measured by using a Macpycno (manufactured by Mountech Co., Ltd.) in accordance with JIS Z 8807: 2012 (gas replacement method).

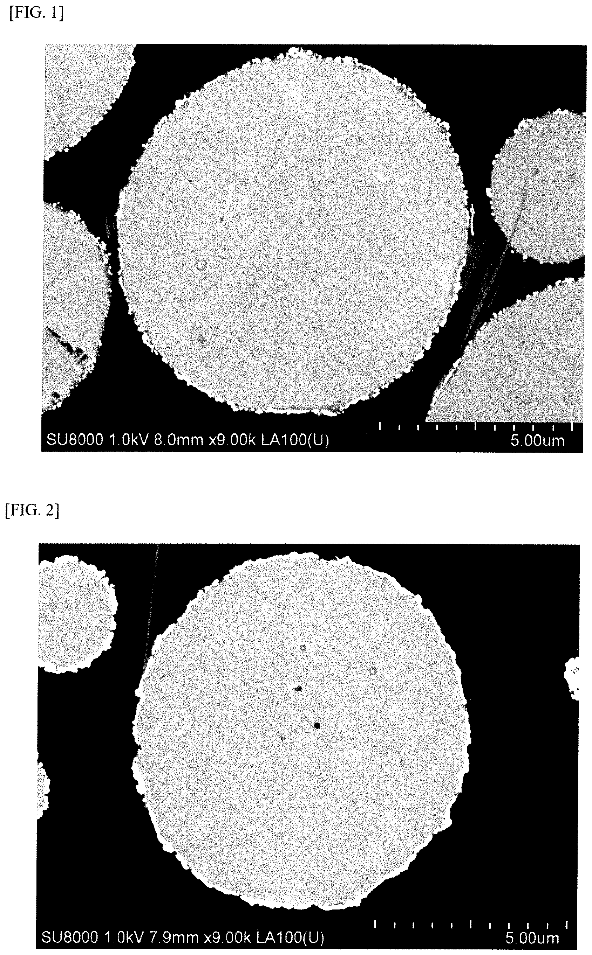

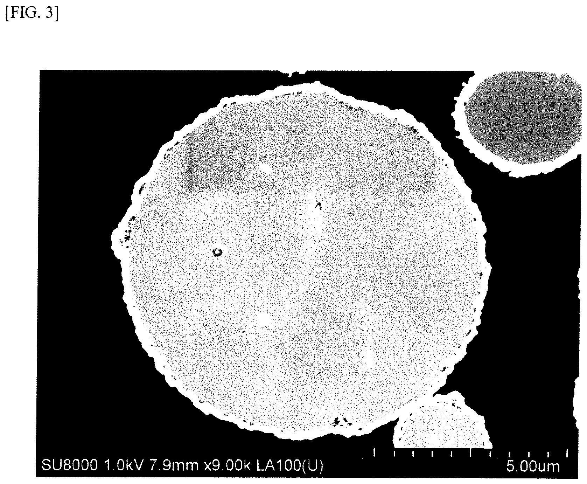

Further, FIG. 1 shows a cross-sectional SEM image of a composite particle in Example 1, FIG. 2 shows a cross-sectional SEM image of a composite particle in Example 2, and FIG. 3 shows a cross-sectional SEM image of a composite particle in Example 3.

### [Table 1]

**Table 1**

| | Base particle | | | | | | | | | | | Coating layer | | |
|---|---|---|---|---|---|---|---|---|---|---|---|---|---|---|
| | Composition (mass%) | | | | Volume average particle diameter D [µm]^{#1} | BET specific surface area [m²/g] | SF-1 | Magnetization properties (VSM@5kOe) | | | Curie temperature [°C] | Constituent material | Ratio to entire particles [mass%] | Thickness T [µm] |
| | Fe | Mn | Mg | Sr | | | | Saturation magnetization σ s [emu/g] | Residual magnetization σ r [emu/g] | Coercive force He [Oe] | | | | |
| Ex. 1 | 47.6 | 18.2 | 2.7 | 0.6 | 7.5 | 0.74 | 110 | 69.6 | 2.724 | 38.23 | 410 | Ag | 6.5 | 0.05 |
| Ex. 2 | 47.6 | 18.2 | 2.7 | 0.6 | 7.5 | 0.74 | 110 | 69.6 | 2.724 | 38.23 | 410 | Ag | 12.9 | 0.10 |
| Ex. 3 | 47.6 | 18.2 | 2.7 | 0.6 | 7.5 | 0.74 | 110 | 69.6 | 2.724 | 38.23 | 410 | Ag | 23.9 | 0.20 |
| Comp. Ex. 1 | 47.6 | 18.2 | 2.7 | 0.6 | 7.5 | 0.74 | 110 | 69.6 | 2.724 | 38.23 | 410 | - | - | - |

| | | | | | | | | | | | | | | |
|---|---|---|---|---|---|---|---|---|---|---|---|---|---|---|
| #1: Measurement by laser diffraction particle diameter distribution measurement device | | | | | | | | | | | | | | |

### [Table 2]

**Table 2**

| | Entire particles (composite particles) | | | | | | | |
|---|---|---|---|---|---|---|---|---|
| | Volume average particle diameter [µm]^{#2} | T/D | Magnetization properties (VSM@5kOe) | | | SF-1 | Tap density [g/cm³] | True gravity [g/cm³] |
| | | | Saturation magnetization σ s [emu/g] | Residual magnetization σ r [emu/g] | Coercive force He [Oe] | | | |
| Ex. 1 | 7.8 | 0.0064 | 64.88 | 2.247 | 36.29 | 110.2 | 2.42 | 5.05622 |
| Ex. 2 | 8.1 | 0.0123 | 59.9 | 1.978 | 35.96 | 109.9 | 2.50 | 5.25496 |
| Ex. 3 | 8.5 | 0.0235 | 51.65 | 1.604 | 35.76 | 109.8 | 2.54 | 5.61624 |
| Comp. Ex. 1 | 7.6 | - | 69.6 | 2.724 | 38.23 | 110.0 | 2.18 | 4.83352 |

| | | | | | | | | |
|---|---|---|---|---|---|---|---|---|
| #2: Measurement by laser diffraction particle diameter distribution measurement device | | | | | | | | |

### (2) Permeability Measurement

Evaluation of the magnetic permeability was performed as follows by using the powder obtained in each of Examples and the Comparative Example.

First, in a glass bottle were placed 10 parts by mass of fluorine powder resin and 90 parts by mass of the above powder (aggregate of a plurality of composite particles), followed by mixing by a ball mill (100 rpm) for 30 minutes and then, 1 g of the mixture was weighed out.

The weighed mixture was put into a doughnut-shaped molding die having an outer diameter of 13 mm and an inner diameter of 4.5 mm, and pressurized at 50 KN for five seconds to obtain a molded article as a sample for permeability measurement.

A magnetic material measurement jig 16454 was connected to a material analyzer E 4991 manufactured by Agilent Technologies, and the obtained sample for permeability measurement was set and subjected to frequency sweep from 1 MHz to 3 GHz to measure frequency dependency of the magnetic permeability.

### (3) Electrical Resistivity

Evaluation of the electrical resistivity was performed as follows by using the powder obtained in each of Examples and the Comparative Example.

First, a fluororesin-made cylinder having a cross-sectional area of 4 cm² was filled with powder as a sample up to the height of 4 mm, then electrodes were attached on two ends thereof, and 1 kg of weight was further placed thereon, and the electrical resistance was measured. In the measurement of electrical resistance, a measurement voltage of 1 V was applied by a 2182A type nanovolt meter manufactured by Keithley, and the resistance after 60 seconds was measured to calculate the volume resistance.

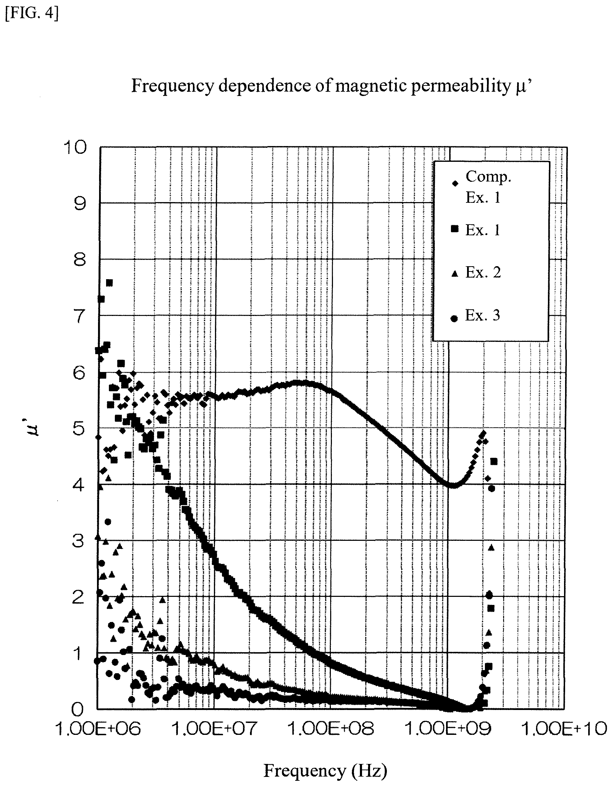

The results of the magnetic permeability of Examples 1 to 3 and Comparative Example 1 are shown in FIG. 4, respectively, and the results of the electrical resistivity thereof are shown in Table 3.

### [Table 3]

**Table 3**

| | Volume resistivity [Ω·cm] |
|---|---|
| Ex. 1 | 3.8 × 10⁰ |
| Ex. 2 | 3.7 × 10⁻³ |
| Ex. 3 | 5.1 × 10⁻⁴ |
| Comp. Ex. 1 | 1.2 × 10⁷ |

As can be seen from FIG. 4 and Table 3, in the present invention, it was confirmed that the frequency dependence of the magnetic permeability (rise of the magnetic permeability µ') is shifted to the low frequency side depending on the thickness of the surface coating layer, and that electromagnetic waves were shielded by the metal coating film (coating layer) present on the surface of the ferrite particles (base particles). In contrast, satisfactory results were not obtained in Comparative Example because there was no metal coating.

### Industrial Applicability

According to the present invention, it is possible to provide a composite particle and powder excellent in an electromagnetic wave-shielding property, to provide a molded article excellent in an electromagnetic wave-shielding property, and further to provide a resin composition that can be preferably used for production of the molded article.

Although the present invention has been described in detail with reference to specific embodiments, it is apparent to those skilled in the art that various changes and modifications can be made within the scope of the appended claims.

## Claims

1. A powder comprising a plurality of composite particles, wherein the composite particles comprise a base particle formed of a ferrite, and wherein the volume average particle diameter of the composite particles is 2.0 µm or more and 15 µm or less,
**characterized in that**
the ferrite has a composition containing Fe in an amount of 48 mass% or more and 65 mass% or less, Mn in an amount of 10 mass% or more and 25 mass% or less, Mg in an amount of 0.1 mass% or more and 6 mass% or less, and Sr in an amount of 1 mass% or less;
wherein the composite particles further comprise a coating layer formed of a material containing at least one selected from the group consisting of Au, Ag, Pt, Ni, and Pd.

2. The powder according to Claim 1, wherein the ferrite is a soft ferrite.

3. The powder according to Claim 1 or 2, wherein the ferrite has a Curie point of 200 °C or higher and 500 °C or lower.

4. The powder according to any one of Claims 1 to 3, wherein the coating layer has a thickness of 10 nm or more and 500 nm or less.

5. The powder according to any one of Claims 1 to 4, wherein the base particle has a spherical shape.

6. A resin composition comprising the powder according to any one of Claims 1 to 5, and a resin material.

7. A molded article comprising the powder according to any one of Claims 1 to 5 and a resin material.

## Patentansprüche

1. Ein Pulver, umfassend eine Mehrzahl an Kompositteilchen, wobei die Kompositteilchen ein aus einem Ferrit gebildetes Basisteilchen umfassen und wobei der volumengemittelte Teilchendurchmesser der Kompositteilchen 2,0 µm oder mehr und 15 µm oder weniger beträgt,
**dadurch gekennzeichnet, dass**
das Ferrit eine Zusammensetzung aufweist, die Fe in einer Menge von 48 Massen-% oder mehr und 65 Massen-% oder weniger, Mn in einer Menge von 10 Massen-% oder mehr und 25 Massen-% oder weniger, Mg in einer Menge von 0,1 Massen-% oder mehr und 6 Massen-% oder weniger, und Sr in einer Menge von 1 Massen-% oder weniger enthält;
wobei die Kompositteilchen ferner eine Überzugsschicht umfassen, die aus einem Material gebildet ist, das mindestens eines, ausgewählt aus der Gruppe bestehend aus Au, Ag, Pt, Ni und Pd, enthält.

2. Das Pulver nach Anspruch 1, wobei das Ferrit ein Weichferrit ist.

3. Das Pulver nach Anspruch 1 oder 2, wobei das Ferrit einen Curie-Punkt von 200°C oder mehr und 500°C oder weniger aufweist.

4. Das Pulver nach einem der Ansprüche 1 bis 3, wobei die Überzugsschicht eine Dicke von 10 nm oder mehr und 500 nm oder weniger aufweist.

5. Das Pulver nach einem der Ansprüche 1 bis 4, wobei das Basisteilchen eine Kugelform aufweist.

6. Eine Harzzusammensetzung, umfassend das Pulver nach einem der Ansprüche 1 bis 5 und ein Harzmaterial.

7. Ein Formgegenstand, umfassend das Pulver nach einem der Ansprüche 1 bis 5 und ein Harzmaterial.

## Revendications

1. Poudre comprenant une pluralité de particules composites, dans laquelle les particules composites comprennent une particule de base formée d'une ferrite, et dans laquelle la moyenne volumique du diamètre de particules composites est de 2,0 µm ou plus et 15 µm ou moins,
**caractérisée en ce que**
la ferrite a une composition contenant du Fe en une quantité de 48 % en masse ou plus et 65 % en masse ou moins, du Mn en une quantité de 10 % en masse ou plus et 25 % en masse ou moins, du Mg en une quantité de 0,1 % en masse ou plus et 6 % en masse ou moins, et du Sr en une quantité de 1 % en masse ou moins ;
dans laquelle les particules composites comprennent en outre une couche de revêtement formée d'un matériau contenant au moins l'un choisi dans le groupe constitué par Au, Ag, Pt, Ni et Pd.

2. Poudre selon la revendication 1, dans laquelle la ferrite est une ferrite douce.

3. Poudre selon la revendication 1 ou 2, dans laquelle la ferrite a un point de Curie de 200 °C ou plus et 500 °C ou moins.

4. Poudre selon l'une quelconque des revendications 1 à 3, dans laquelle la couche de revêtement a une épaisseur de 10 nm ou plus et 500 nm ou moins.

5. Poudre selon l'une quelconque des revendications 1 à 4, dans laquelle la particule de base a une forme sphérique.

6. Composition de résine comprenant la poudre selon l'une quelconque des revendications 1 à 5, et un matériau de résine.

7. Article moulé comprenant la poudre selon l'une quelconque des revendications 1 à 5 et un matériau de résine.
